(19) Europäisches Patentamt
European Patent Office
Office européen des brevets

(11) **EP 2 668 512 B1**

(12) **EUROPÄISCHE PATENTSCHRIFT**

(45) Veröffentlichungstag und Bekanntmachung des Hinweises auf die Patenterteilung:
**24.06.2015   Patentblatt 2015/26**

(21) Anmeldenummer: **11715694.3**

(22) Anmeldetag: **14.04.2011**

(51) Int Cl.:
*G01R 15/16* (2006.01)     *G01R 31/312* (2006.01)
*G01R 29/12* (2006.01)     *G01R 15/14* (2006.01)
*G01R 19/00* (2006.01)     *G01R 19/155* (2006.01)
*G01R 19/165* (2006.01)

(86) Internationale Anmeldenummer:
**PCT/EP2011/055936**

(87) Internationale Veröffentlichungsnummer:
**WO 2012/139648 (18.10.2012 Gazette 2012/42)**

(54) **VERFAHREN ZUM BERÜHRUNGSLOSEN BESTIMMEN EINES ELEKTRISCHEN POTENTIALS EINES OBJEKTS DURCH ZWEI VERSCHIEDENE WERTE FÜR DEN ELEKTRISCHEN FLUSS SOWIE VORRICHTUNG**

METHOD FOR THE CONTACTLESS DETERMINATION OF AN ELECTRICAL POTENTIAL OF AN OBJECT USING TWO DIFFERENT VALUES FOR THE ELECTRIC FLUX, AND DEVICE

PROCÉDÉ DE DÉTERMINATION SANS CONTACT D'UN POTENTIEL ÉLECTRIQUE D'UN OBJET AU MOYEN DE DEUX VALEURS DE FLUX ÉLECTRIQUE DIFFÉRENTES ET DISPOSITIF ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**04.12.2013   Patentblatt 2013/49**

(73) Patentinhaber: **Siemens Aktiengesellschaft 80333 München (DE)**

(72) Erfinder:
• **SCHIMMER, Jürgen 90473 Nürnberg (DE)**
• **MAKUTH, Jens 90537 Feucht (DE)**
• **SCHEIBNER, Dirk 90473 Nürnberg (DE)**

(56) Entgegenhaltungen:
DE-A1-102009 022 965     US-A- 5 473 244
US-A1- 2007 086 130     US-A1- 2011 148 393

**Beschreibung**

Die Erfindung betrifft ein Verfahren sowie eine Vorrichtung zum berührungslosen Bestimmen eines elektrischen Potentials eines Objekts unter Verwendung einer oder einer ersten und einer zweiten Elektrode.

Es ist bekannt, den Stromfluss durch ein Objekt berührungslos zu messen. Dies kann über induktive Kopplung, den Hall-Effekt oder den GMR(Giant Magneto Resistance)-Effekt erfolgen. Um berührungslos elektrische Leistung messen zu können, ist jedoch neben der berührungslosen Strommessung auch ein Verfahren zur berührungslosen Potentialmessung erforderlich. Die berührungslose Potentialmessung, insbesondere hoher Spannungen, ist v.a. im Bereich Smart Metering, Smart Grid und Response-Demand-Strategien von besonderer Bedeutung.

Eine Möglichkeit hierfür bieten so genannte Elektrofeldmeter. Diese nutzen den Effekt der Influenz, um über die ermittelte elektrische Feldstärke auf die zu bestimmende Spannung schließen zu können. Dafür müssen jedoch der Abstand zwischen dem Objekt, dessen Potential bestimmt werden soll, und der Messelektrode des Elektrofeldmeters sowie das Material (Dielektrikum) zwischen Messelektrode und Objekt in der Messkapazität exakt bekannt sein. Um mit einem Elektrofeldmeter auch Gleichspannungen messen zu können, wird in der Regel zwischen der Messelektrode und dem Objekt ein Shutter (Feldblende) in Form eines Choppers (Flügelrad) eingesetzt.

Für die Bestimmung reiner Wechselspannungen sind auch kapazitive Spannungsteiler nutzbar, wobei hier ebenfalls die Koppelkapazität zwischen einer Referenzelektrode und dem zu messenden Potential bekannt sein muss.

Beide Verfahren bzw. Vorrichtungen (Elektrofeldmeter und kapazitiver Spannungsteiler) setzen eine genaue Kenntnis der Ankopplung an die zu messende Spannung voraus, insbesondere des Abstands zwischen Messelektrode und Messobjekt. Insofern sind diese bekannten Verfahren für nur temporäre Messvorgänge oder nachträgliche Messinstallationen ungeeignet. Elektrofeldmeter und kapazitive Spannungsteiler werden für präzise Messungen fest installiert und in der Einbauumgebung kalibriert. Bei Handmessgeräten ist eine exakte Kenntnis der Geometrie und stofflichen Beschaffenheit (Leitungsisolation, Luft, Gas, Betauung, etc.) des Messaufbaus nötig. Dazu werden bei handelsüblichen Elektrofeldmetern zum Beispiel spezielle Abstandshalter benutzt. Abstandshalter haben jedoch den Nachteil, dass sie insbesondere für die Potentialbestimmung elektrisch isolierter Leitungen nicht direkt auf dem leitenden Material aufsitzen und damit den Abstand nur unzureichend genau einstellen. Zudem kann die Art des isolierenden Materials nicht berücksichtigt werden. Reicht diese Präzision der bekannten berührungslosen Potentialmessverfahren nicht aus, muss üblicherweise kontaktierend gemessen werden.

Aus der DE 10 2009 022965 A1 ist bereits ein Verfahren zum berührungslosen Bestimmen eines elektrischen Potentials eines Objektes mittels zweier Elektroden bekannt, wobei eine Bestimmung der zeitlichen Veränderungen des Ladezustands der Elektroden und Ermittlung des Potentials des Objektes aus der zeitlichen Veränderung des Ladezustands erfolgt, und die Differenz des ersten und zweiten Werts für den elektrischen Fluß ermittelt wird.

Auch die US 5,473,244 beschreibt eine Vorrichtung zur kontaktlosen Messung mittels Elektroden.

Aus der US 2007/0086130 A1 ist eine Anordnung bekannt mit zwei Gruppen von kapazitiven Sensoren, welche kreisförmig um einen Leiter angeordnet sind.

Es ist Aufgabe der Erfindung, ein Verfahren sowie eine Vorrichtung bereitzustellen, mit denen eine berührungslose Potentialmessung auch bei zunächst unbekannter Koppelkapazität möglich ist.

Diese Aufgabe wird durch ein Verfahren, welches die Merkmale des Patentanspruchs 1 aufweist sowie eine Vorrichtung mit den Merkmalen des Patentanspruchs 6 gelöst.

Ein erstes erfindungsgemäßes Verfahren dient zum berührungslosen Bestimmen eines elektrischen Potentials eines Objekts und umfasst die folgenden Schritte:

-     Bereitstellen einer Elektrode, welche von dem Objekt räumlich beabstandet ist;
-     Verbinden der Elektrode mit einem Bezugspotential;
-     Bestimmen einer ersten zeitlichen Veränderung eines elektrischen Ladezustands der Elektrode bei einem ersten Wert für den elektrischen Fluss zwischen der Elektrode und dem Objekt;
-     Bestimmen einer zweiten zeitlichen Veränderung des elektrischen Ladezustands der Elektrode bei einem zweiten Wert für den elektrischen Fluss zwischen der Elektrode und dem Objekt;
-     Ermitteln des elektrischen Potentials des Objekts zumindest aus der ersten und zweiten zeitlichen Veränderung des elektrischen Ladezustands sowie aus einer Differenz des ersten Werts und des zweiten Werts für den elektrischen Fluss.

Das Verfahren erlaubt es, dass für eine Bestimmung des elektrischen Potentials des Objekts keine vorherige Kenntnis des Abstands der Elektrode von dem Objekt und/oder einer Dielektrizitätskonstante (zum Beispiel des Materials einer Kabelisolation) zwischen der Elektrode und dem Objekt erforderlich ist. Das Verfahren umfasst insbesondere Teilschritte, die als Schritte einer Autokalibrierung aufgefasst werden können. Hierdurch kann eine exakte mechanische Justage beziehungsweise ein definierter Festeinbau einer Messvorrichtung gegenüber dem Objekt entfallen. Auch dynamische Veränderungen im Messaufbau (Temperatureinflüsse, Druckänderungen, Feuchtigkeit etc.. und hierdurch bedingte Änderungen im Abstand oder der Dielektrizitätskonstante) können kompensiert werden. Es ist ein robustes und universell einsetzbares Verfahren zur berührungslosen Potentialmessung geschaffen.

Unter dem ersten und zweiten Wert für den elektrischen Fluss zwischen der Elektrode und dem Objekt kann jeder Wert verstanden werden, der geeignet ist, den elektrischen Fluss zu charakterisieren. Insbesondere kann es sich bei dem Wert um eine Spannung der Elektrode gegenüber einem Bezugspotential handeln. Als Wert kann beispielsweise auch eine elektrische Feldstärke dienen. Auch der Wert eines Umladestroms, welcher zwischen der Elektrode und einem Bezugspotential fließt, kann Rückschlüsse auf den elektrischen Fluss zwischen der Elektrode und dem Objekt zulassen. Beispielsweise kann ein an der Elektrode anliegendes Referenzpotential eine Größe darstellen, welche den Wert für den elektrischen Fluss charakterisiert. Dann kann insbesondere die Differenz der den elektrischen Fluss charakterisierenden Werte durch Subtraktion einer ersten Referenzspannung bei einem ersten Wert für den elektrischen Fluss und einer zweiten Referenzspannung bei einem zweiten Wert für den elektrischen Fluss gebildet werden. Der Wert für den elektrischen Fluss zwischen der Elektrode und dem Objekt kann insbesondere durch eine Veränderung des Abstands zwischen Elektrode und Objekt und/oder Veränderung der Dielektrizitätskonstante eines Materials zwischen Elektrode und Objekt und/oder aktives Laden der Elektrode über ein Referenzpotential erfolgen.

Vorzugsweise erfolgt das Einstellen des ersten Wertes für den elektrischen Fluss zwischen der Elektrode und dem Objekt durch Positionieren der Elektrode in einem ersten Abstand zu dem Objekt und Einstellen des Bezugspotentials auf einen ersten Potentialwert. Dann erfolgt das Einstellen des zweiten Werts für den elektrischen Fluss zwischen der Elektrode und dem Objekt durch Positionieren der Elektrode in dem ersten Abstand zu dem Objekt und Einstellen des Bezugspotentials auf einen zweiten Potentialwert, welcher von dem ersten Potentialwert verschieden ist. Durch die unterschiedlichen Potentialwerte bei gleichem Abstand werden zwei unterschiedliche elektrische Feldstärken eingestellt, so dass über eine Differenzbildung dieser Feldstärken in der Berechnung die unbekannte Feldstärke wegfällt. Dies erlaubt es, die Kapazität der Anordnung aus Objekt und Elektrode auch ohne explizite Kenntnis des Abstands zwischen Objekt und Elektrode und/oder die Elektrizitätskonstante im Medium zwischen Elektrode und Objekt zu berechnen. Insgesamt ist der Messablauf sehr einfach und eine unbekannte Kapazität ist über eine Referenzpotentialänderung bestimmbar.

Alternativ kann vorgesehen sein, dass das Einstellen des ersten Werts für den elektrischen Fluss zwischen der Elektrode und dem Objekt durch Positionieren der Elektrode in einem ersten Abstand zu dem Objekt und Einstellen des Bezugspotentials auf einen ersten Potentialwert erfolgt und das Einstellen des zweiten Werts für den elektrischen Fluss zwischen der Elektrode und dem Objekt durch Positionieren der Elektrode in einem zweiten Abstand zu dem Objekt, welcher von dem ersten Abstand verschieden ist, und Einstellen des Bezugspotentials auf den ersten Potentialwert erfolgt. Ein und dieselbe Elektrode wird also nacheinander in zwei verschiedenen Abständen zu dem Objekt positioniert, wobei das Bezugspotential an der Elektrode konstant gehalten wird. Dann stehen wiederum zwei geeignete Werte zur Verfügung, die eine Ermittlung der unbekannten Kapazität der Kondensatoranordnung und anschließend eine Ermittlung des unbekannten Potentials erlauben.

Ein zweites erfindungsgemäßes Verfahren dient zum berührungslosen Bestimmen eines elektrischen Potentials eines Objekts und umfasst die folgenden Schritte:

- Bereitstellen einer ersten und einer zweiten Elektrode, welche von dem Objekt räumlich beabstandet sind;
- Verbinden der ersten Elektrode mit einem ersten Bezugspotential und Verbinden der zweiten Elektrode mit einem zweiten Bezugspotential;
- Bestimmen einer ersten zeitlichen Veränderung eines elektrischen Ladezustands der ersten Elektrode bei einem ersten Wert für den elektrischen Fluss zwischen der ersten Elektrode und dem Objekt;
- Bestimmen einer zweiten zeitlichen Veränderung des elektrischen Ladezustands der zweiten Elektrode bei einem zweiten Wert für den elektrischen Fluss zwischen der zweiten Elektrode und dem Objekt;
- Ermitteln des elektrischen Potentials des Objekts zumindest aus der ersten und zweiten zeitlichen Veränderung des elektrischen Ladezustands sowie aus einer Differenz des ersten Werts und des zweiten Werts für den elektrischen Fluss.

Im Gegensatz zu dem ersten erfindungsgemäßen Verfahren wird gemäß dem zweiten erfindungsgemäßen Verfahren nunmehr eine erste und eine zweite Elektrode bereitgestellt. Für die Einstellung der unterschiedlichen Werte für den elektrischen Fluss zwischen der ersten Elektrode und dem Objekt ist dann keine Veränderung von Parametern an einer einzigen Elektrode mehr erforderlich. Vielmehr können durch die erste Elektrode und ihre relative Anordnung zu dem Objekt erste Parameter eingestellt sein und durch die zweite Elektrode zweite Parameter eingestellt sein, welche gemeinsam Rückschlüsse auf die Koppelkapazität zwischen den Elektroden und dem Objekt erlauben. Das Bestimmen des elektrischen Potentials des Objekts kann gemäß diesem Verfahren gegebenenfalls schneller ablaufen als gemäß dem ersten Verfahren. Es ist eine robuste und schnell arbeitende Anordnung für die Durchführung des Verfahrens geschaffen.

Vorzugsweise erfolgt das Einstellen des ersten Werts für den elektrischen Fluss zwischen der ersten Elektrode und dem Objekt durch Positionieren der ersten Elektrode in einem ersten Abstand zu dem Objekt und Einstellen des ersten Bezugspotentials auf einen ersten Potentialwert. Dann erfolgt das Einstellen des zweiten Werts für den elektrischen Fluss zwischen der zweiten Elektrode und dem Objekt durch Positionieren der zweiten Elektrode in dem ersten Abstand zu dem Objekt und Einstellen des zweiten Bezugspotentials auf einen zweiten Potentialwert, welcher von dem ersten Potentialwert verschieden ist.

Alternativ kann vorgesehen sein, dass das Einstellen des ersten Werts für den elektrischen Fluss zwischen der ersten Elektrode und dem Objekt durch Positionieren der ersten Elektrode in einem ersten Abstand zu dem Objekt und Einstellen des ersten Bezugspotentials auf einen ersten Potentialwert erfolgt. Dann ist vorgesehen, dass das Einstellen des zweiten Werts für den elektrischen Fluss zwischen der zweiten Elektrode und dem Objekt durch Positionieren der zweiten Elektrode in einem zweiten Abstand zu dem Objekt, welcher von dem ersten Abstand verschieden ist, und Einstellen des zweiten Bezugspotentials auf den ersten Potentialwert erfolgt. Alternativ sind auch andere Kombinationen möglich, wobei beispielsweise die erste Elektrode und die zweite Elektrode unterschiedliche Abstände zu dem Objekt einnehmen und zudem auf verschiedene Bezugspotentiale gelegt sind. Es ergibt sich eine Vielzah1 an Freiheitsgraden in der Ausgestaltung des Messverfahrens. Bei keinem der Messverfahren ist die Kenntnis eines absoluten Abstands einer der Elektroden von dem Objekt erforderlich.

Die erste und zweite Elektrode müssen nicht identisch ausgebildet sein. Es kann insbesondere nur erforderlich sein, dass ein Zusammenhang zwischen kapazitätsbeeinflussenden Größen zwischen den beiden Elektroden bekannt ist. Hat beispielsweise die erste Elektrode eine andere Elektrodenfläche als die zweite Elektrode, so muss gegebenenfalls die Elektrodenfläche einer der Elektroden absolut bekannt sein und Klarheit darüber herrschen, in welchem Verhältnis die Fläche der zweiten Elektrode zu jener der ersten Elektrode steht. Besonders bevorzugt ist es allerdings, wenn die erste Elektrode und die zweite Elektrode identisch ausgebildet sind. Dann ist das Messverfahren mithilfe zweier Elektroden mit jeweils unterschiedlichen Parameterwerten zu ein und demselben Zeitpunkt äquivalent zu einer Messdurchführung mit nur einer einzigen Elektrode mit den jeweils unterschiedlichen Parametern zu zwei verschiedenen Zeitpunkten. Allerdings kann die Messung mit den zwei Elektroden schneller erfolgen und es bedarf gegebenenfalls keiner zeitveränderlichen Komponenten und beweglichen Bauteile.

Vorzugsweise erfolgt das Bestimmen der zeitlichen Veränderung des elektrischen Ladezustands in der zumindest einen Elektrode durch Messung eines Umladestroms. Der Umladestrom kann insbesondere durch ein Strommessgerät gemessen werden, welches zwischen der Elektrode und einem Bezugspotentialträger angeordnet ist. Die Messung kann sehr genau erfolgen.

Vorzugsweise ist die zumindest eine Elektrode mit einem ersten Eingang eines Verstärkers und das Bezugspotential mit einem zweiten Eingang des Verstärkers und ein Ausgang des Verstärkers mit dem ersten Eingang elektrisch verbunden. Diese Messanordnung ist besonders vorteilhaft, um ein definiertes Bezugspotential an der Elektrode einzustellen.

Vorzugsweise wird mittels des Verfahrens ein zeitlich veränderliches elektrisches Potential des Objekts bestimmt. Eine Feldblende beziehungsweise ein Chopper kann dann entfallen.

Alternativ kann jedoch auch vorgesehen sein, dass zwischen der zumindest einen Elektrode und dem Objekt ein rotierendes Flügelrad (Chopper) und/oder eine Feldblende und/oder ein Shutter angeordnet wird und ein zeitlich konstantes elektrisches Potential des Objekts bestimmt wird. Mittels des Flugelrads kann periodisch ein feldfreier Referenzzustand hergestellt werden, der auch bei statischen Potentialen eine Messung über das Prinzip der Influenz erlaubt. Die Verfahren sind auf diese Art besonders universell einsetzbar.

Eine erste erfindungsgemäße Vorrichtung dient zur berührungslosen Bestimmung eines elektrischen Potentials eines Objekts und umfasst eine Elektrode, welche von dem Objekt räumlich beabstandet anordenbar ist. Die Vorrichtung umfasst ferner einen Potentialgeber, welcher mit der Elektrode elektrisch verbunden ist, und eine Auswerteeinheit, welche dazu ausgebildet ist, eine erste zeitliche Veränderung eines elektrischen Ladezustands der Elektrode bei einem ersten Wert für den elektrischen Fluss zwischen der Elektrode und dem Objekt zu bestimmen, und eine zweite zeitliche Veränderung des elektrischen Ladezustands der Elektrode bei einem zweiten Wert für den elektrischen Fluss zwischen der Elektrode und dem Objekt zu bestimmen, und das elektrische Potential des Objekts zumindest aus der ersten und zweiten zeitlichen Veränderung des elektrischen Ladezustands sowie aus einer Differenz des ersten Werts und des zweiten Werts für den elektrischen Fluss zu bestimmen.

Eine zweite erfindungsgemäße Vorrichtung dient ebenfalls zur berührungslosen Bestimmung eines elektrischen Potentials eines Objekts und umfasst eine erste und eine zweite Elektrode, welche von dem Objekt räumlich beabstandet anordenbar sind. Die Vorrichtung umfasst ferner einen ersten Potentialgeber, welcher mit der ersten Elektrode elektrisch verbunden ist, einen zweiten Potentialgeber, welcher mit der zweiten Elektrode elektrisch verbunden ist, und eine Auswerteeinheit, welche dazu ausgebildet ist, eine erste zeitliche Veränderung eines elektrischen Ladezustands der ersten Elektrode bei einem ersten Wert für den elektrischen Fluss zwischen der ersten Elektrode und dem Objekt zu bestimmen, und eine zweite zeitliche Veränderung des elektrischen Ladezustands der zweiten Elektrode bei einem zweiten Wert für den elektrischen Fluss zwischen der zweiten Elektrode und dem Objekt zu bestimmen, und das elektrische Potential des Objekts zumindest aus der ersten und zweiten zeitlichen Veränderung des elektrischen Ladezustands sowie aus einer Differenz des ersten Werts und des zweiten Werts für den elektrischen Fluss zu bestimmen.

Die mit Bezug auf die erfindungsgemäßen Verfahren dargestellten bevorzugten Ausführungsformen und deren Vorteile gelten entsprechend für die erfindungsgemäßen Vorrichtungen.

Anhand von Ausführungsbeispielen wird die Erfindung im Folgenden näher erläutert. Es zeigen:

FIG 1 eine schematische Darstellung einer Vorrichtung zur berührungslosen Bestimmung eines elektrischen Potentials gemäß einem ersten Ausführungsbeispiel; und

FIG 2 eine schematische Darstellung einer Vorrichtung zur berührungslosen Bestimmung eines elektrischen Potentials gemäß einem zweiten Ausführungsbeispiel.

In den Figuren sind gleiche und funktionsgleiche Elemente mit den gleichen Bezugszeichen versehen.

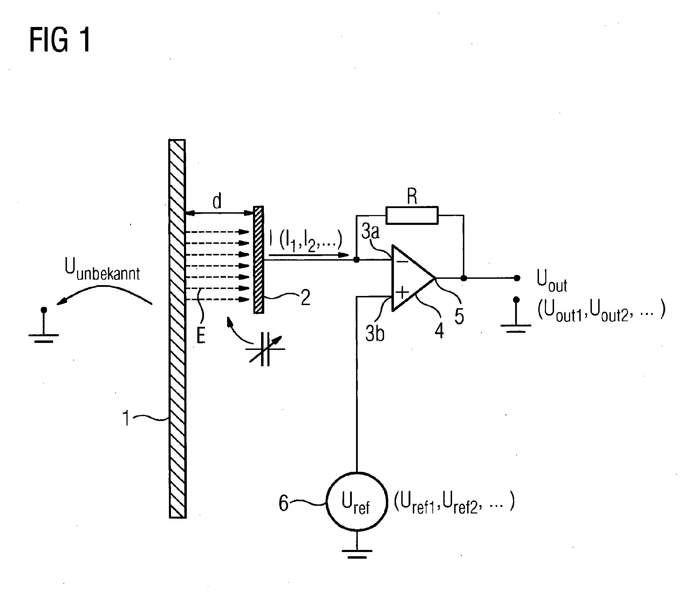

FIG 1 zeigt eine Leitung 1, deren unbekanntes Potential $U_{unbekannt}$ bestimmt werden soll. Hierfür ist in einem (unbekannten) Abstand d eine Messelektrode 2 angeordnet. Die Leitung 1 bildet gemeinsam mit der Messelektrode 2 einen Kondensator mit einer Kapazität C. Im Ausführungsbeispiel sei von einem einfachen Plattenkondensator, dessen Innenraum von einem elektrischen Feld E durchsetzt wird, ausgegangen. Zudem sei das unbekannte Potential $U_{unbekannt}$ im Ausführungsbeispiel ein zeitlich veränderliches Wechselpotential. Weder der Plattenabstand d noch die Dielektrizitätskonstante ε des zwischen der Messelektrode 2 und der Leitung 1 vorliegenden Mediums sind genau bekannt. Es wird deshalb ein Verfahren angewandt, mit dem sich das unbekannte Potential $U_{unbekannt}$ auch ohne Kenntnis dieser Größen bestimmen lässt.

Die Messelektrode 2 ist nicht elektrisch isoliert, sondern mit einer Messanordnung elektrisch verbunden. Der aufgrund von Influenzwirkung in der Messelektrode 2 hervorgerufene Umladestrom I kann so gemessen werden. Alternativ kann auch eine Ausgangsspannung $U_{out}$ ermittelt werden. Hierfür ist eine Messanordnung mit einem Verstärker 4 vorgesehen, welcher über einen ersten Eingang 3a und einen zweiten Eingang 3b sowie einen Ausgang 5 verfügt. Die Messelektrode 2 ist mit dem ersten Eingang 3a des Verstärkers 4 elektrisch verbunden, während ein Potentialgeber 6 mit dem zweiten Eingang 3b elektrisch verbunden ist. Zudem ist der Ausgang 5 über einen elektrischen Widerstand R mit dem ersten Eingang 3a elektrisch verbunden. Über den Potentialgeber 6 kann ein Referenzpotential $U_{ref}$ an der Messelektrode 2 eingestellt werden. Je nach Stärke des eingestellten Referenzpotentials $U_{ref}$ wird das im Kondensator herrschende elektrische Feld E zumindest teilweise kompensiert oder verstärkt. Auf diese Art verfügt der Kondensator über eine variabel Kapazität C.

Gemäß dem Ausführungsbeispiel der FIG 1 erfolgt die Messung des unbekannten Potentials $U_{unbekannt}$ durch Einstellen zweier unterschiedlicher Referenzpotentiale $U_{ref1}$ und $U_{ref2}$ mittels des Potentialgebers 6. Der Abstand d bleibt hierbei unverändert. Es ergeben sich folgende physikalische Zusammenhänge:

- für den Potentialunterschied zwischen den Platten des Kondensators gilt:

$$\Delta \hat{U}_1 = \hat{U}_{unbekannt} - \hat{U}_{ref1}$$

$$\Delta \hat{U}_2 = \hat{U}_{unbekannt} - \hat{U}_{ref2}$$

- der jeweils fließende Umladestrom I beträgt:

$$I_1 = \hat{I}_1 e^{i\omega t} = C \frac{d(\Delta U_1)}{dt} = \omega e^{i\omega t} \left( \hat{U}_{unbekannt} - \hat{U}_{ref1} \right)$$

$$I_2 = \hat{I}_2 e^{i\omega t} = C \frac{d(\Delta U_2)}{dt} = \omega e^{i\omega t} \left( \hat{U}_{unbekannt} - \hat{U}_{ref2} \right)$$

- für die Differenz der Umladeströme $I_1$ und $I_2$ ergibt sich:

$$I_1 - I_2 = \left(\hat{I}_1 - \hat{I}_2\right)e^{i\omega t}$$
$$= C\omega e^{i\omega t}\left(\hat{U}_{ref2} - \hat{U}_{ref1}\right)$$

- damit kann man aus zwei Messpunkten auf die Koppelkapazität C schließen:

$$C = \frac{\hat{I}_1 - \hat{I}_2}{\omega \cdot \left(\hat{U}_{ref2} - \hat{U}_{ref1}\right)}$$

In der Herleitung wird von starren Phasenbeziehungen ausgegangen, die durch eine Nachführung der Phase von $U_{ref}$ gegenüber I erreicht werden kann. Die mit Dach (^) versehenen Größen stellen dabei die Amplituden des Umladestroms I beziehungsweise des Referenzpotentials $U_{ref}$ dar.

Diese Herleitung stellt nur eine mögliche Auswertevariante der Referenzmessungen dar. Sie ist insbesondere für sinusförmige Spannungsverläufe geeignet. Bei komplexeren Signalen ist auch ein völlig entkoppeltes Referenzsignal (zum Beispiel ein Rauschen) denkbar. Die Auswertung kann dann zum Beispiel über eine Kreuzkorrelation erfolgen.

Für FIG 1 seien die wesentlichen physikalischen Zusammenhänge nochmals gesammelt dargestellt:

$$C = \frac{\varepsilon \cdot A}{d}$$

$$E = \frac{\Delta U}{d}$$

$$I = C\frac{d(\Delta U)}{dt}$$

$$U_{out} = -R \cdot I = -RC\frac{d(\Delta U)}{dt}$$

$\varepsilon$ ist hierbei die Dielektrizitätskonstante innerhalb der Kondensatoranordnung aus Leitung 1 und Messelektrode 2. A ist die Fläche der Messelektrode 2.

Gemäß der in FIG 1 dargestellten Ausführungsform werden mindestens zwei Messungen nacheinander an derselben Messelektrode 2 mit verschiedenen Referenzpotentialen $U_{ref1}$ und $U_{ref2}$ durchgeführt. Aus der Verrechnung der jeweils entstehenden Ausgangssignale wird auf die unbekannte Messkapazität und auf das unbekannte Potential $U_{unbekannt}$ der Leitung 1 geschlossen.

Alternativ ist es jedoch auch möglich, $U_{ref}$ konstant beizubehalten und Messungen bei zwei verschiedenen Abständen d durchzuführen.

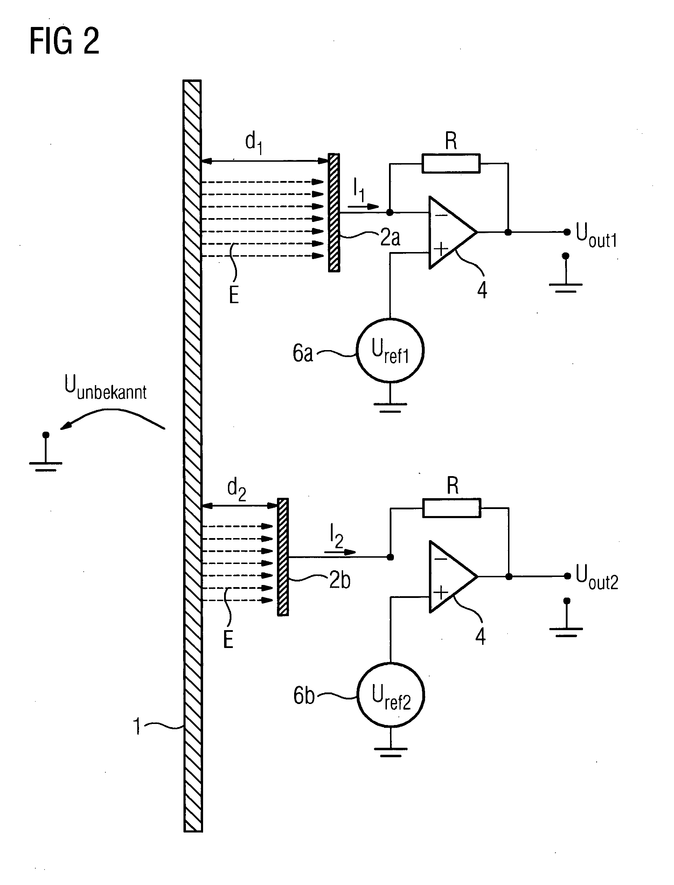

Ein ähnlicher Weg ist im Ausführungsbeispiel gemäß FIG 2 beschritten, wobei nunmehr jedoch zwei identisch ausgebildete Messelektroden 2a und 2b vorgesehen sind, die im Abstand $d_1$ beziehungsweise $d_2$ gegenüber der Leitung 1 angeordnet sind. Jede der Messelektroden 2a und 2b ist jeweils mit einer Auswerteschaltung verbunden, die insbesondere einen ersten Potentialgeber 6a und einen zweiten Potentialgeber 6b zur Einstellung jeweils eines Referenzpotentials $U_{ref1}$ beziehungsweise $U_{ref2}$ umfasst. Es kann dann eine gleichzeitige Messung an den beiden Messelektroden 2a und 2b durchgeführt werden, um die für die Bestimmung der Koppelkapazität C gemäß obiger Gleichung erforderlichen Eingangsgrößen zu erhalten.

Gemäß dem Ausführungsbeispiel der FIG 2 besitzen die Referenzpotentiale $U_{ref1}$ und $U_{ref2}$ denselben Wert, das heißt $U_{ref1} = U_{ref2}$. Die erforderliche Einstellung unterschiedlicher Messparameter erfolgt durch die voneinander verschiedenen Abstände $d_1$ und $d_2$. Alternativ kann jedoch auch vorgesehen sein, dass zumindest zwei Messungen an den zwei unterschiedlichen Messelektroden 2a und 2b bei identischem Abstand ($d_1 = d_2$) und verschiedenen Referenzpotentialen $U_{ref1}$ und $U_{ref2}$ gegebenenfalls gleichzeitig durchgeführt werden. Auch eine Kombination beider Verfahren ist möglich. Dann befinden sich die Messelektroden 2a und 2b wie in FIG 2 gezeigt in unterschiedlichem Abstand $d_1$ beziehungsweise $d_2$ zur Leitung 1 und es werden auch voneinander verschiedene Referenzpotentiale $U_{ref1}$ und $U_{ref2}$ an den Messelektroden 2a beziehungsweise 2b eingestellt. Auch dann ist eine gleichzeitige Durchführung der zwei erforderlichen Messungen möglich.

Zusammenfassend erfolgt also die Variation des Referenzpotentials $U_{ref}$ beziehungsweise des Abstands d für mindestens zwei Referenzmessungen beziehungsweise Kalibrationsmessungen. Durch Messung der Influenzwirkung beim jeweiligen Referenzpotential $U_{ref}$ beziehungsweise Abstand d erhält man jeweils ein zugehöriges Ausgangssignal (Umladestrom I an der Messelektrode 2 oder Ausgangsspannung $U_{out}$). Aus der Verrechnung von mindestens zwei solchen Ausgangssignalen ist ein Rückschluss auf das zu messende Potential $U_{unbekannt}$ beziehungsweise auf die Koppelkapazität C möglich, ohne dass eine exakte Kenntnis der Koppelkapazität C beziehungsweise der Geometrie und stofflichen Beschaffenheit der Anordnung im Kondensator erforderlich wäre.

Bezugszeichenliste

| | |
|---|---|
| 1 | Leitung |
| 2, 2a, 2b | Messelektrode |
| 3a, 3b | Eingang |
| 4 | Verstärker |
| 5 | Ausgang |
| 6, 6a, 6b | Potentialgeber |
| $U_{unbekannt}$ | Potential |
| $\hat{U}_{unbekannt}$ | Amplitude des Potentials |
| d, $d_1$, $d_2$ | Abstand |
| $U_{ref}$, $U_{ref1}$, $U_{ref2}$ | Referenzpotential |
| $\hat{U}_{ref}$, $\hat{U}_{ref1}$, $\hat{U}_{ref2}$ | Amplitude des Referenzpotentials |
| I, $I_1$, $I_2$ | Umladestrom |
| $\hat{I}$, $\hat{I}_1$, $\hat{I}_2$ | Amplitude des Umladestroms |
| $U_{out}$, $U_{out1}$, $U_{out2}$ | Ausgangsspannung |
| R | elektrischer Widerstand |
| E | elektrisches Feld |
| C | Kapazität |
| A | Fläche |
| $\varepsilon$ | Dielektrizitätskonstante |
| $\Delta U_1$, $\Delta U_2$ | Potentialunterschied |

**Patentansprüche**

1.  Verfahren zum berührungslosen Bestimmen eines elektrischen Potentials ($U_{unbekannt}$) eines Objekts (1) mit den Schritten:

    - Bereitstellen einer Elektrode (2), welche von dem Objekt (1) räumlich beabstandet ist,
    - Verbinden der Elektrode (2) mit einem Bezugspotential ($U_{ref}$);
    - Bestimmen einer ersten zeitlichen Veränderung eines elektrischen Ladezustands ($I_1$) der Elektrode (2) bei einem ersten Wert für den elektrischen Fluss zwischen der Elektrode (2) und dem Objekt (1);
    - Bestimmen einer zweiten zeitlichen Veränderung des elektrischen Ladezustands ($I_2$) der Elektrode (2) bei einem zweiten Wert für den elektrischen Fluss zwischen der Elektrode (2) und dem Objekt (1) ;
    - Ermitteln des elektrischen Potentials ($U_{unbekannt}$) des Objekts (1) zumindest aus der ersten ($I_1$) und zweiten zeitlichen Veränderung des elektrischen Ladezustands ($I_2$) sowie aus einer Differenz des ersten Werts und des zweiten Werts für den elektrischen Fluss;

    **gekennzeichnet durch** die Schritte:

    - Einstellen des ersten Werts für den elektrischen Fluss zwischen der Elektrode (2) und dem Objekt (1) **durch** Positionieren der Elektrode (2) in einem ersten Abstand ($d_1$) zu dem Objekt (1) und Einstellen des Bezugspotentials auf einen ersten Potentialwert ($U_{ref1}$);

- Einstellen des zweiten Werts für den elektrischen Fluss zwischen der Elektrode (2) und dem Objekt (1) **durch** Positionieren der Elektrode (2) in dem ersten Abstand ($d_1$) zu dem Objekt (1) und Einstellen des Bezugspotentials auf einen zweiten Potentialwert ($U_{ref2}$), welcher von dem ersten Potentialwert ($U_{ref1}$) verschieden ist.

2. Verfahren nach Anspruch 1, **dadurch gekennzeichnet, dass** das Bestimmen der zeitlichen Veränderung des elektrischen Ladezustands der zumindest einen Elektrode (2, 2a, 2b) durch Messung eines Umladestroms ($I$, $I_1$, $I_2$) erfolgt.

3. Verfahren nach einem der vorhergehenden Ansprüche, **dadurch gekennzeichnet, dass** die zumindest eine Elektrode (2, 2a, 2b) mit einem ersten Eingang (3a) eines Verstärkers (4) und das Bezugspotential ($U_{ref}$) mit einem zweiten Eingang (3b) des Verstärkers (4) und ein Ausgang (5) des Verstärkers (4) mit dem ersten Eingang (3a) elektrisch verbunden wird.

4. Verfahren nach einem der vorhergehenden Ansprüche, **dadurch gekennzeichnet, dass** ein zeitlich veränderliches elektrisches Potential ($U_{unbekannt}$) des Objekts (1) bestimmt wird.

5. Verfahren nach einem der vorhergehenden Ansprüche, **dadurch gekennzeichnet, dass** zwischen der zumindest einen Elektrode (2, 2a, 2b) und dem Objekt (1) ein rotierendes Flügelrad angeordnet wird und ein zeitlich konstantes elektrisches Potential ($U_{unbekannt}$) des Objekts (1) bestimmt wird.

6. Vorrichtung zur berührungslosen Bestimmung eines elektrischen Potentials ($U_{unbekannt}$) eines Objekts (1) mit einer Elektrode (2), welche von dem Objekt (1) räumlich beabstandet anordenbar ist, und einem Potentialgeber (6), welcher mit der Elektrode (2) elektrisch verbunden ist, und einer Auswerteeinheit, welche dazu ausgebildet ist, eine erste zeitliche Veränderung eines elektrischen Ladezustands ($I_1$) der Elektrode (2) bei einem ersten Wert für den elektrischen Fluss zwischen der Elektrode (2) und dem Objekt (1) zu bestimmen, und eine zweite zeitliche Veränderung des elektrischen Ladezustands ($I_2$) der Elektrode (2) bei einem zweiten Wert für den elektrischen Fluss zwischen der Elektrode (2) und dem Objekt (1) zu bestimmen, und das elektrische Potential ($U_{unbekannt}$) des Objekts (1) zumindest aus der ersten ($I_1$) und zweiten zeitlichen Veränderung des elektrischen Ladezustands ($I_2$) sowie aus einer Differenz des ersten Werts und des zweiten Werts für den elektrischen Fluss zu bestimmen,
**dadurch gekennzeichnet, dass**
der erste Wert für den elektrischen Fluss zwischen der Elektrode (2) und dem Objekt (1) durch Positionieren der Elektrode (2) in einem ersten Abstand ($d_1$) zu dem Objekt (1) und Einstellen eines Bezugspotentials, mit dem die Elektrode (2) verbunden ist, auf einen ersten Potentialwert ($U_{ref1}$) einstellbar ist; und dass der zweite Wert für den elektrischen Fluss zwischen der Elektrode (2) und dem Objekt (1) durch Positionieren der Elektrode (2) in dem ersten Abstand ($d_1$) zu dem Objekt (1) und Einstellen des Bezugspotentials auf einen zweiten Potentialwert ($U_{ref2}$), welcher von dem ersten Potentialwert ($U_{ref1}$) verschieden ist, einstellbar ist.

**Claims**

1. Method for the contactless determination of an electrical potential ($U_{unknown}$) of an object (1), having the step of:

    - providing an electrode (2) which is spatially at a distance from the object (1),
    - connecting the electrode (2) to a reference potential ($U_{ref}$);
    - determining a first temporal change in an electrical state of charge ($I_1$) of the electrode (2) at a first value for the electric flux between the electrode (2) and the object (1);
    - determining a second temporal change in the electrical state of charge ($I_2$) of the electrode (2) at a second value for the electric flux between the electrode (2) and the object (1);
    - determining the electrical potential ($U_{unknown}$) of the object (1) at least from the first temporal change in the electrical state of charge ($I_1$) and the second temporal change in the electrical state of charge ($I_2$) and from a difference between the first value and the second value for the electric flux;

    **characterized by** the steps of:

    - setting the first value for the electric flux between the electrode (2) and the object (1) by positioning the electrode (2) at a first distance ($d_1$) from the object (1) and setting the reference potential to a first potential value ($U_{ref1}$);
    - setting the second value for the electric flux between the electrode (2) and the object (1) by positioning the electrode (2) at the first distance ($d_1$) from the object (1) and setting the reference potential to a second potential value ($U_{ref2}$) which is different from the first potential value ($U_{ref1}$).

2. Method according to Claim 1, **characterized in that** the temporal change in the electrical state of charge of the at least one electrode (2, 2a, 2b) is determined by measuring a charge reversal current ($I$, $I_1$, $I_2$).

3. Method according to one of the preceding claims, **characterized in that** the at least one electrode (2, 2a, 2b) is electrically connected to a first input (3a) of an amplifier (4) and the reference potential ($U_{ref}$) is electrically connected to a second input (3b) of the amplifier (4) and an output (5) of the amplifier (4) is electrically connected to the first input (3a).

4. Method according to one of the preceding claims, **characterized in that** a temporally variable electrical potential ($U_{unknown}$) of the object (1) is determined.

5. Method according to one of the preceding claims, **characterized in that** a rotating impeller is arranged between the at least one electrode (2, 2a, 2b) and the object (1) and a temporally constant electrical potential ($U_{unknown}$) of the object (1) is determined.

6. Device for the contactless determination of an electrical potential ($U_{unknown}$) of an object (1) using an electrode (2) which can be spatially arranged at a distance from the object (1), and
a potential generator (6) which is electrically connected to the electrode (2), and an evaluation unit which is designed to determine a first temporal change in an electrical state of charge ($I_1$) of the electrode (2) at a first value for the electric flux between the electrode (2) and the object (1) and to determine a second temporal change in the electrical state of charge ($I_2$) of the electrode (2) at a second value for the electric flux between the electrode (2) and the object (1) and to determine the electrical potential ($U_{unknown}$) of the object (1) at least from the first temporal change in the electrical state of charge ($I_1$) and the second temporal change in the electrical state of charge ($I_2$) and from a difference between the first value and the second value for the electric flux, **characterized in that**
the first value for the electric flux between the electrode (2) and the object (1) can be set by positioning the electrode (2) at a first distance ($d_1$) from the object (1) and setting a reference potential, to which the electrode (2) is connected, to a first potential value ($U_{ref1}$); and **in that** the second value for the electric flux between the electrode (2) and the object (1) can be set by positioning the electrode (2) at the first distance ($d_1$) from the object (1) and setting the reference potential to a second potential value ($U_{ref2}$) which is different from the first potential value ($U_{ref1}$).

## Revendications

1. Procédé pour la détermination sans contact d'un potentiel électrique ($U_{inconnu}$) d'un objet (1) comprenant les étapes consistant à :

   - mettre à disposition une électrode (2), laquelle est spatialement à distance de l'objet (1) ;
   - relier l'électrode (2) à un potentiel de référence ($U_{réf}$) ;
   - déterminer une première variation temporelle d'un état de charge électrique ($I_1$) de l'électrode (2) dans le cas d'une première valeur pour le courant électrique entre l'électrode (2) et l'objet (1) ;
   - déterminer une deuxième variation temporelle de l'état de charge électrique ($I_2$) de l'électrode (2) dans le cas d'une deuxième valeur pour le courant électrique entre l'électrode (2) et l'objet (1) ;
   - définir le potentiel électrique ($U_{inconnu}$) de l'objet (1) au moins à partir de la première ($I_1$) et de la deuxième variation temporelle de l'état de charge électrique ($I_2$) ainsi que d'une différence de la première valeur et de la deuxième valeur pour le courant électrique ; **caractérisé par** les étapes consistant à :

      -- régler la première valeur pour le courant électrique entre l'électrode (2) et l'objet (1) par le positionnement de l'électrode (2) à une première distance ($d_1$) par rapport à l'objet (1) et régler le potentiel de référence à une première valeur de potentiel ($U_{réf1}$) ;

      - régler la deuxième valeur pour le courant électrique entre l'électrode (2) et l'objet (1) par le positionnement de l'électrode (2) à la première distance ($d_1$) par rapport à l'objet (1) et régler le potentiel de référence à une deuxième valeur de potentiel ($U_{réf2}$), laquelle est différente de la première valeur de potentiel ($U_{réf1}$).

2. Procédé selon la revendication 1, **caractérisé en ce que** la détermination de la variation temporelle de l'état de charge électrique de l'au moins une électrode [2, 2a, 2b) se produit par le biais de la mesure d'un courant de recharge (I, I$_1$, I$_2$).

3. Procédé selon l'une des revendications précédentes, **caractérisé en ce que** l'au moins une électrode (2, 2a, 2b) est reliée électriquement à une première entrée (3a) d'un amplificateur (4) et le potentiel de référence (U$_{réf}$) est relié électriquement à une deuxième entrée (3b) de l'amplificateur (4) et une sortie (5) de l'amplificateur (4) est reliée électriquement à la première entrée (3a).

4. Procédé selon l'une des revendications précédentes, **caractérisé en ce qu'**un potentiel électrique modifié temporellement (U$_{inconnu}$) de l'objet (1) est déterminé.

5. Procédé selon l'une des revendications précédentes, **caractérisé en ce que**, entre l'au moins une électrode (2, 2a, 2b) et l'objet (1) est disposée une roue hélice rotative et un potentiel électrique temporellement constant (U$_{inconnu}$) de l'objet (1) est déterminé.

6. Dispositif pour la détermination sans contact d'un potentiel électrique (U$_{inconnu}$) d'un objet (1) comprenant une électrode (2), laquelle peut être agencée spatialement à distance de l'objet (1), et
un indicateur de potentiel (6), lequel est relié électriquement à l'électrode (2), et une unité d'évaluation, laquelle est configurée pour déterminer une première variation temporelle d'un état de charge électrique (I$_1$) de l'électrode (2) dans le cas d'une première valeur pour le courant électrique entre l'électrode (2) et l'objet (1), et pour déterminer une deuxième variation temporelle de l'état de charge électrique (I$_2$) de l'électrode (2) dans le cas d'une deuxième valeur pour le courant électrique entre l'électrode (2) et l'objet (1), et pour déterminer le potentiel électrique (U$_{inconnu}$) de l'objet (1) au moins à partir de la première (I$_1$) et de la deuxième variation temporelle de l'état de charge électrique (I$_2$) ainsi qu'à partir d'une différence de la première valeur et de la deuxième valeur pour le courant électrique,
**caractérisé en ce que**
la première valeur pour le courant électrique entre l'électrode (2) et l'objet (1) peut être réglée pour le courant électrique entre l'électrode (2) et l'objet (1) par le positionnement de l'électrode (2) à une première distance (d$_1$) par rapport à l'objet (1) et le réglage d'un potentiel de référence, auquel l'électrode (2) est reliée, à une première valeur de potentiel (U$_{réf1}$) ; et **en ce que** la deuxième valeur pour le courant électrique entre l'électrode (2) et l'objet (1) peut être réglée par le positionnement de l'électrode (2) à la première distance (d$_1$) par rapport à l'objet (1) et le réglage du potentiel de référence à une deuxième valeur de potentiel (U$_{réf2}$), laquelle est différente du premier potentiel (U$_{réf1}$).

FIG 1

## FIG 2

**IN DER BESCHREIBUNG AUFGEFÜHRTE DOKUMENTE**

**In der Beschreibung aufgeführte Patentdokumente**

- DE 102009022965 A1
- US 5473244 A
- US 20070086130 A1